# EUROPEAN PATENT APPLICATION

(11) **EP 1 213 864 A1**
(43) Date of publication of application: **12.06.2002**
(21) Application number: 01984463.8
(22) Date of filing: 30.07.2001
(51) Int. Cl.: H04J 13/04

(54) **MULTICARRIER CDMA COMMUNICATION DEVICE**

(30) Priority: 31.07.2000 JP 2000230471
(71) Applicant: MATSUSHITA ELECTRIC INDUSTRIAL CO., LTD., Kadoma-shi, Osaka 571-8501 (JP)
(72) Inventor: KITAGAWA, Keiichi, Yokosuka-shi, Kanagawa 239-0847 (JP); SUMASU, Atsushi, Yokosuka-shi, Kanagawa 238-0013 (JP); KATO, Osamu, Yokosuka-shi, Kanagawa 237-0066 (JP)
(74) Representative: Grünecker, Kinkeldey, Stockmair & Schwanhäusser Anwaltssozietät
(86) International application number: JP0106517
(87) International publication number: WO0211334

(57) **Abstract**

A multi-carrier CDMA communication apparatus that suppresses peak power of a multi-carrier signal while suppressing reduction of the transmission efficiency. Serial/parallel conversion section 101 converts transmission data with a single sequence to transmission data with a plurality of sequences. Spreading sections 102-1 to 102-4 perform spreading processing on transmission data with the 1st to 4th sequence. IFFT section 103 multiplexes the transmission data with the 1st to 4th sequence on the 1st to 4th subcarriers respectively to generate a multi-carrier signal. Peak detection section 104 detects peak power of the generated multi-carrier signal. Chip transmission stopping section 105 outputs a multi-carrier signal whose peak power is not greater than a threshold to D/A conversion section 106 using the detection result of peak detection section 104.

## Description

### Technical Field

The present invention relates to a multi-carrier CDMA communication apparatus, and more particularly, to a multi-carrier CDMA communication apparatus combining a multi-carrier transmission system and a CDMA transmission system.

### Background Art

A multi-carrier CDMA communication which combines a multi-carrier transmission system and a CDMA transmission system is becoming a focus of attention and investigations into this system are being actively pursued recently. This multi-carrier CDMA system is generally categorized as an "MC/DS-CDMA system" and "MC-CDMA system". A communication apparatus using each of the above-described systems will be explained below.

1st, a communication apparatus using the MC/DS-CDMA system (hereinafter simply referred to as "MC/DS-CDMA communication apparatus") will be explained with reference to FIG.1 to FIG.4. FIG.1 is a block diagram showing a configuration of a conventional MC/DS-CDMA communication apparatus. FIG.2 is a schematic view conceptually showing transmission data to be input to the conventional MC/DS-CDMA communication apparatus. FIG.3 is a schematic view conceptually showing transmission data with a plurality of sequences in the conventional MC/DS-CDMA communication apparatus. FIG.4 is a schematic view conceptually showing transmission data with a plurality of sequences after spreading processing in the conventional MC/DS-CDMA communication apparatus.

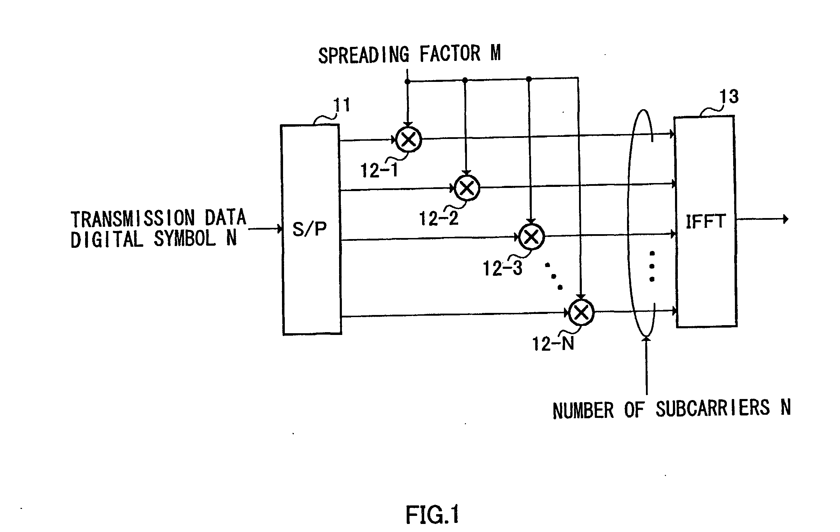

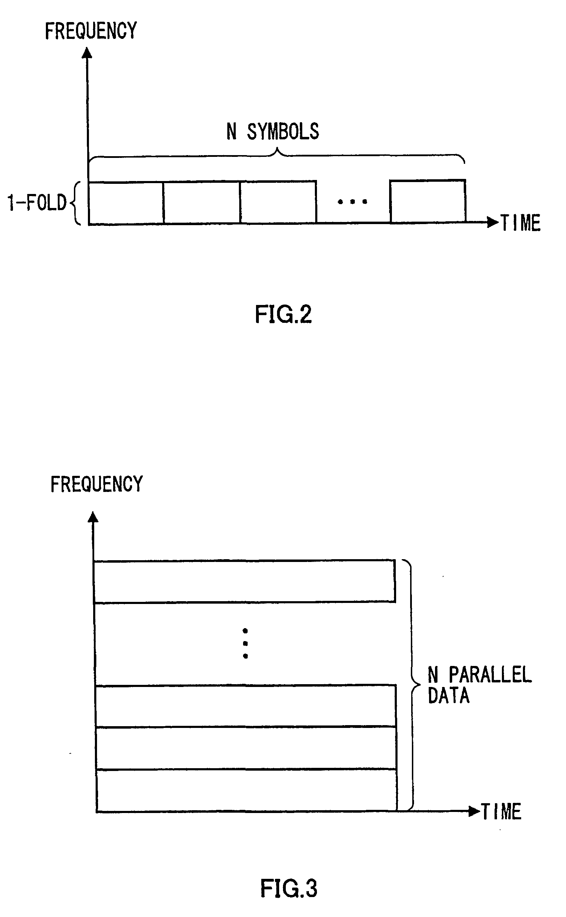

In FIG.1, transmission data with a single sequence (e.g., transmission data corresponding to N symbols: see FIG.2) is converted to transmission data with a plurality of sequences by serial/parallel (hereinafter referred to as "S/P") conversion section 11 (see FIG.3). Here, the number of sequences corresponds to the total number of subcarriers (N). For convenience of explanation, the transmission data with a plurality of sequences shown in FIG.1 is called "transmission data with a 1st to Nth sequence" from top to bottom. Here, the transmission data with the 1st to the Nth symbol corresponds to the transmission data with the 1st to Nth sequence.

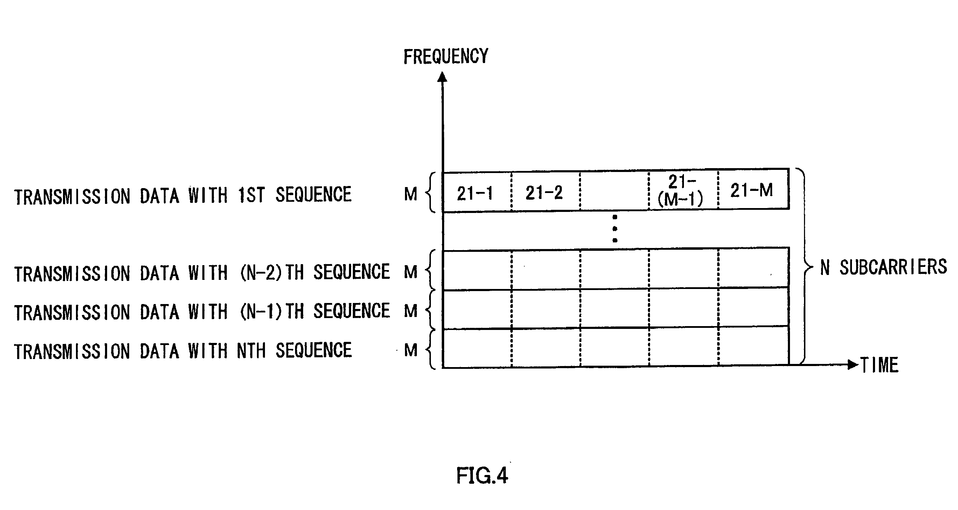

The transmission data with the 1st to Nth sequence are subjected to spreading processing by spreading section 12-1 to spreading section 12-N using a spreading code with spreading factor M, respectively. This causes the transmission data from the 1st to Nth sequence to become chip-based signals with frequency bands spread M times as shown in FIG.4. For example, the transmission data with the 1st sequence is subjected to spreading processing whereby its frequency band is spread M times and converted to a chip-based signal made up of 1st chip 21-1 to Mth chip 21-M.

Inverse Fast Fourier Transform (hereinafter referred to as "IFFT") section 13 carries out IFFT processing (that is, frequency division multiplexing processing) using the transmission data with the 1st to Nth sequence after the spreading processing. This frequency division multiplexing processing generates a multi-carrier signal with the transmission data with the 1st to Nth sequence after the spreading processing multiplexed on the 1st to Nth subcarrier, respectively.

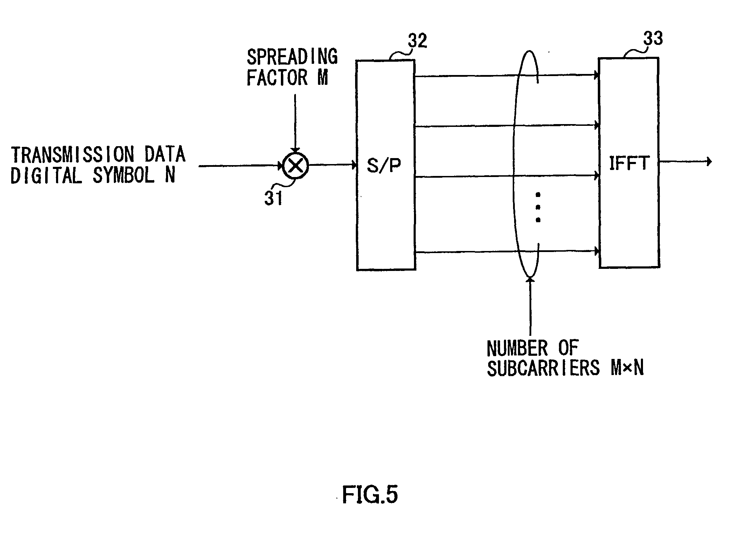

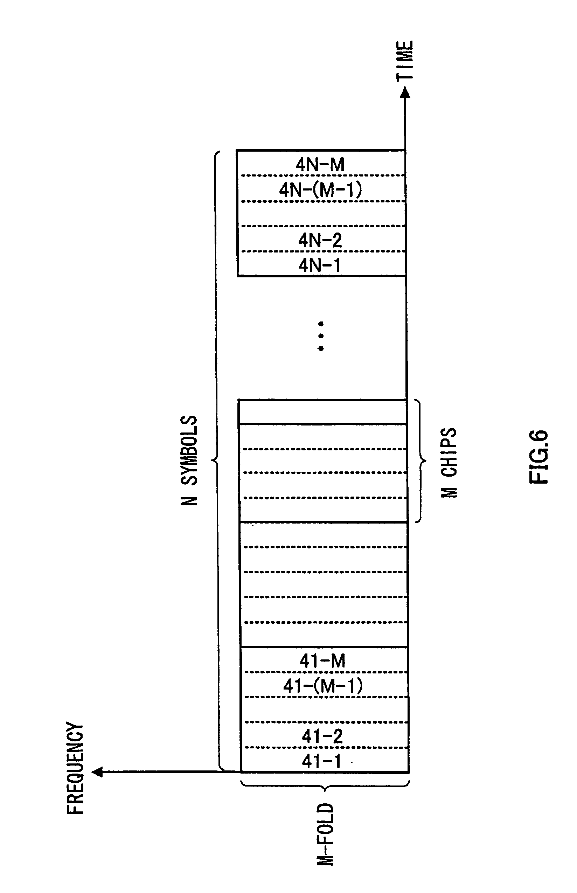

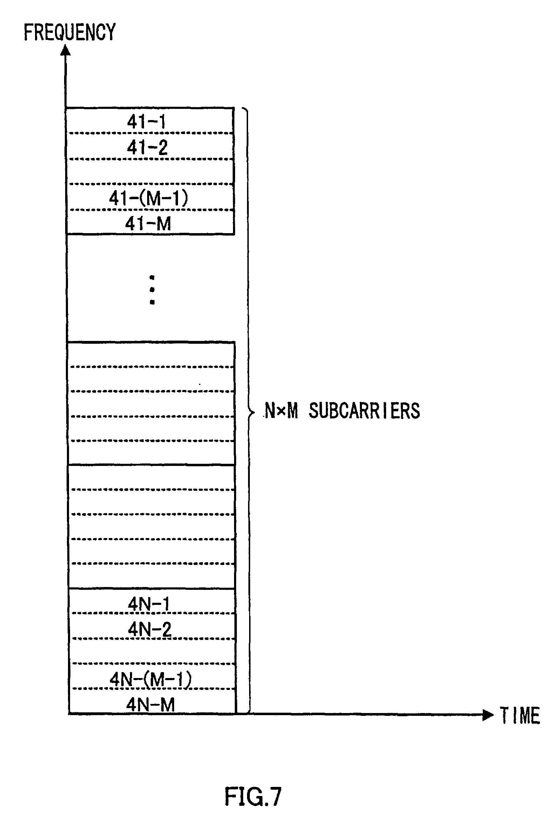

Then, a communication apparatus using an MC-CDMA system (hereinafter simply referred to as "MC-CDMA communication apparatus") will be explained with reference to FIG.5 to FIG.7. FIG.5 is a block diagram showing a configuration of a conventional MC-CDMA communication apparatus. FIG.6 is a schematic view conceptually showing transmission data with a single sequence after spreading processing at the conventional MC-CDMA communication apparatus. FIG.7 is a schematic view conceptually showing transmission data with a plurality of sequences of the conventional MC-CDMA communication apparatus.

In FIG.5, transmission data with a single sequence (e.g., transmission data corresponding to N symbols: see FIG.2) is subjected to spreading processing by spreading section 31 using a spreading code with spreading factor M. This causes the transmission data with a single sequence to become a chip-based signal with its frequency band spread M times (1st chip 41-1 to (M×N)th chip 4N-M) as shown in FIG.6. For example, the transmission data with the 1st symbol is subjected to spreading processing with its frequency band spread M times and becomes a chip-based signal made up of 1st chip 41-1 to Mth chip 41-M.

The transmission data with a single sequence after the spreading processing is converted to transmission data with a plurality of sequences by S/P conversion section 32. The number of sequences here corresponds to the total number of subcarriers (M×N). For convenience of explanation, the transmission data with a plurality of sequences shown in FIG.5 is called "transmission data from the 1st to (M×N)th sequence" from top to bottom. Here, 1st chip 41-1 to (M×N)th chip 4N-M become transmission data with the 1st sequence to the (M×N)th sequence as shown in FIG.7.

IFFT section 33 carries out IFFT processing using the transmission data with the 1st sequence to the (M×N)th sequence. This IFFT processing generates a multi-carrier signal with the transmission data with the 1st to (M×N)th sequence multiplexed on the 1st to (M×N)th subcarrier, respectively.

However, the above-described conventional multi-carrier CDMA system communication involves the following problems. That is, the multi-carrier transmission system has a defect that peak power with respect to average power of a multi-carrier signal increases in proportion to the number of subcarriers. This increases the influence of non-linear distortion on a power amplification section, increasing out-of-band spectral emissions. Such a problem can also occur in a multi-carrier CDMA system combining a multi-carrier transmission system and CDMA transmission system in the same way.

To solve this problem, a method of suppressing peak power of a multi-carrier signal is proposed in multi-carrier transmission, which consists of generating a compensation signal whose phase is opposite to the phase of a multi-carrier signal at a time at which peak power exceeding a threshold appears and generating a multi-carrier signal with this signal placed on a specific subcarrier called a "compensation carrier" (a subcarrier provided independently of subcarriers to transmit an information signals) (TECHNICAL REPORT OF IEICE RCS99-144 (1999-11)) "Peak Power Suppression Method using Parity Carrier in Multi-Carrier Transmission"). This method is also applicable to a multi-carrier CDMA system.

However, when such a method is applied, although it is possible to suppress peak power of a multi-carrier signal with a compensation signal placed on a compensation carrier, the total number of subcarriers to transmit information signals is reduced by an amount corresponding to this compensation carrier. That is, the compensation carrier can be said to be a subcarrier that contributes to suppression of peak power, but not to information transmission. As a result, this produces a new problem of reducing the transmission efficiency in the above-described conventional multi-carrier CDMA transmission.

### Disclosure of Invention

It is an object of the present invention to provide a multi-carrier CDMA communication apparatus capable of suppressing peak power of a multi-carrier signal while suppressing reduction of the transmission efficiency.

According to a mode of the present invention, the multi-carrier CDMA communication apparatus includes converting means for converting an information signal with a single sequence to information signals with a plurality of sequences subjected to spreading processing, generating means for multiplexing the above-described spread information signals with a plurality of sequences on their respective sequence-specific carriers to generate a multi-carrier signal, peak power detecting means for detecting peak power of the above-described multi-carrier signal and transmitting means for transmitting only a multi-carrier signal whose peak power is not greater than a threshold.

### Brief Description of Drawings

FIG.1 is a block diagram showing a configuration of a conventional MC/DS-CDMA communication apparatus;
FIG.2 is a schematic view conceptually showing transmission data to be input to the conventional MC/DS-CDMA communication apparatus;
FIG.3 is a schematic view conceptually showing transmission data with a plurality of sequences in the conventional MC/DS-CDMA communication apparatus;
FIG.4 is a schematic view conceptually showing transmission data with a plurality of sequences after spreading processing in the conventional MC/DS-CDMA communication apparatus;
FIG.5 is a block diagram showing a configuration of a conventional MC-CDMA communication apparatus;
FIG.6 is a schematic view conceptually showing transmission data with a single sequence after spreading processing at the conventional MC-CDMA communication apparatus;
FIG.7 is a schematic view conceptually showing transmission data with a plurality of sequences at the conventional MC-CDMA communication apparatus;

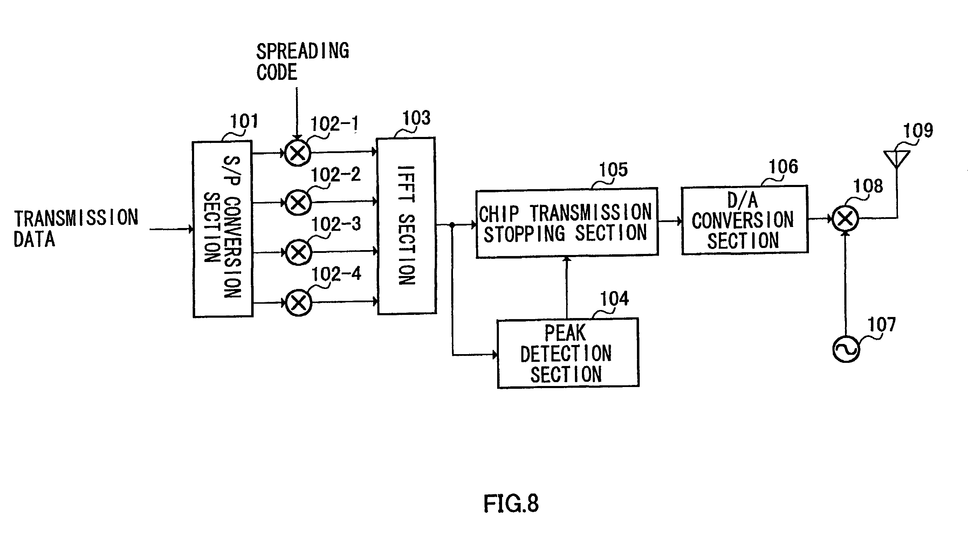

FIG.8 is a block diagram showing a configuration of a transmission apparatus equipped with a multi-carrier CDMA communication apparatus according to Embodiment 1 of the present invention;

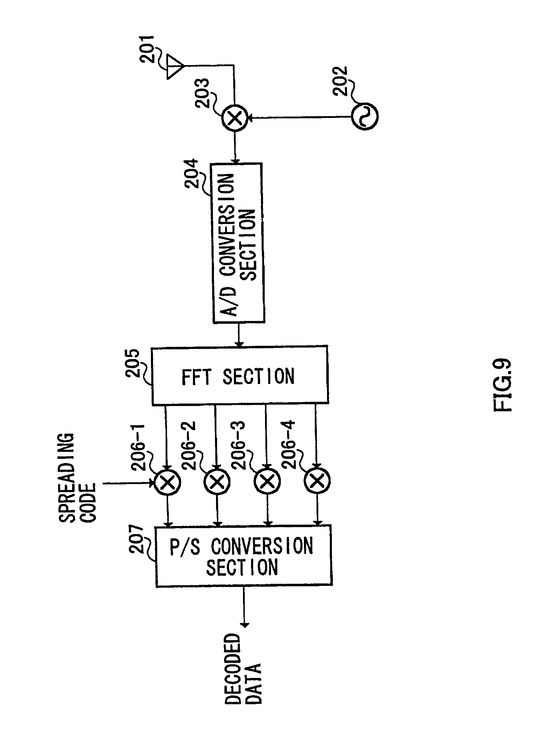

FIG.9 is a block diagram showing a configuration of a reception apparatus equipped with the multi-carrier CDMA communication apparatus according to Embodiment 1;

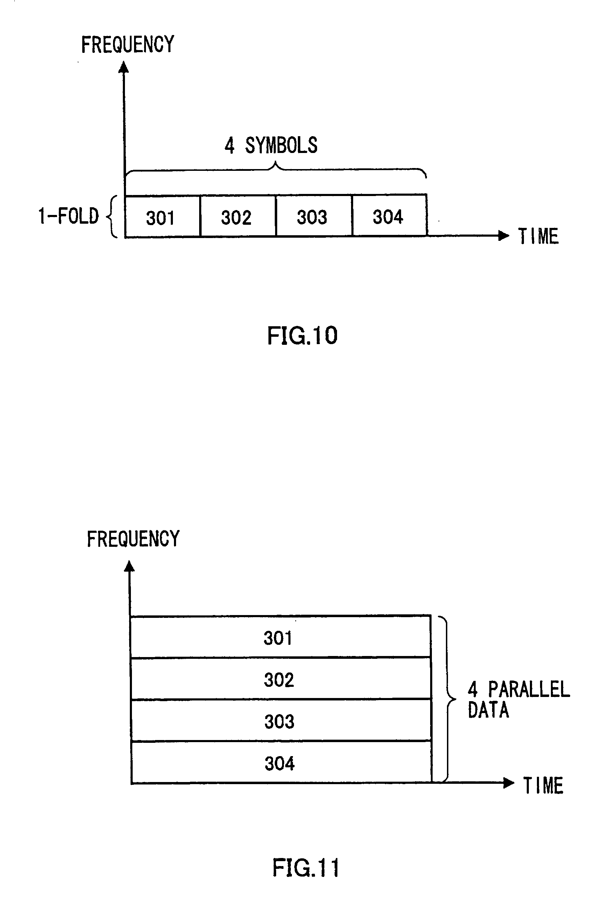

FIG.10 is a schematic view conceptually showing an example of transmission data to be input to a transmission apparatus equipped with the multi-carrier CDMA communication apparatus according to Embodiment 1;
FIG.11 is a schematic view conceptually showing an example of transmission data with a plurality of sequences at the transmission apparatus equipped with the multi-carrier CDMA communication apparatus according to Embodiment 1;

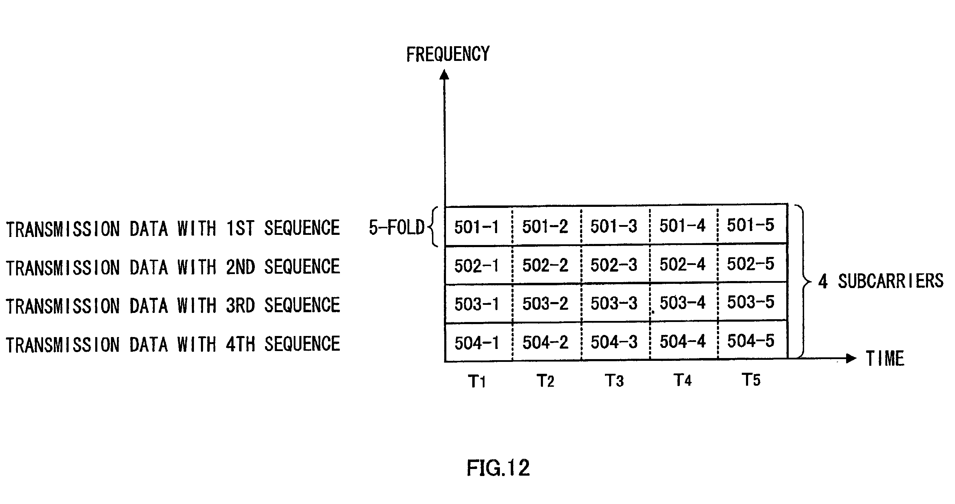

FIG.12 is a schematic view conceptually showing transmission data with a plurality of sequences after spreading processing at the transmission apparatus equipped with the multi-carrier CDMA communication apparatus according to Embodiment 1;

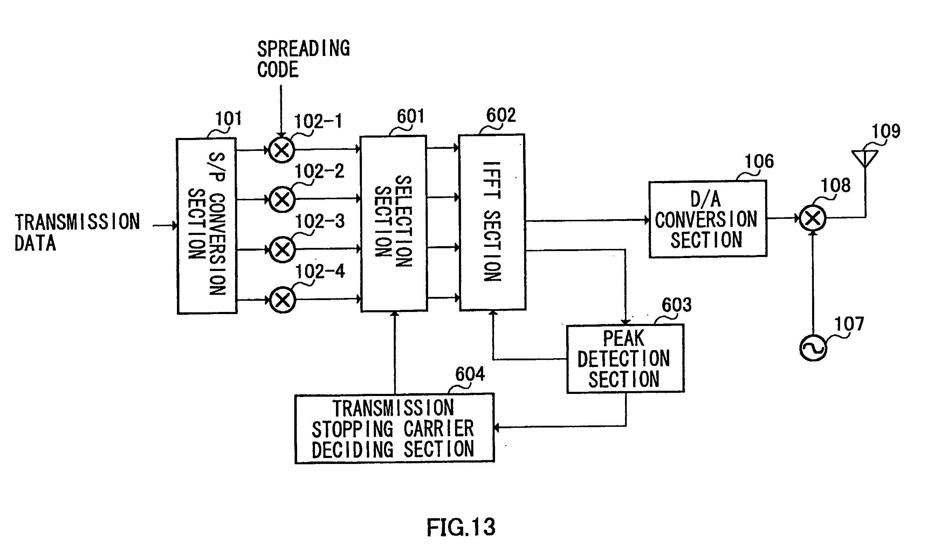

FIG.13 is a block diagram showing a configuration of a transmission apparatus equipped with a multi-carrier CDMA communication apparatus according to Embodiment 2 of the present invention;

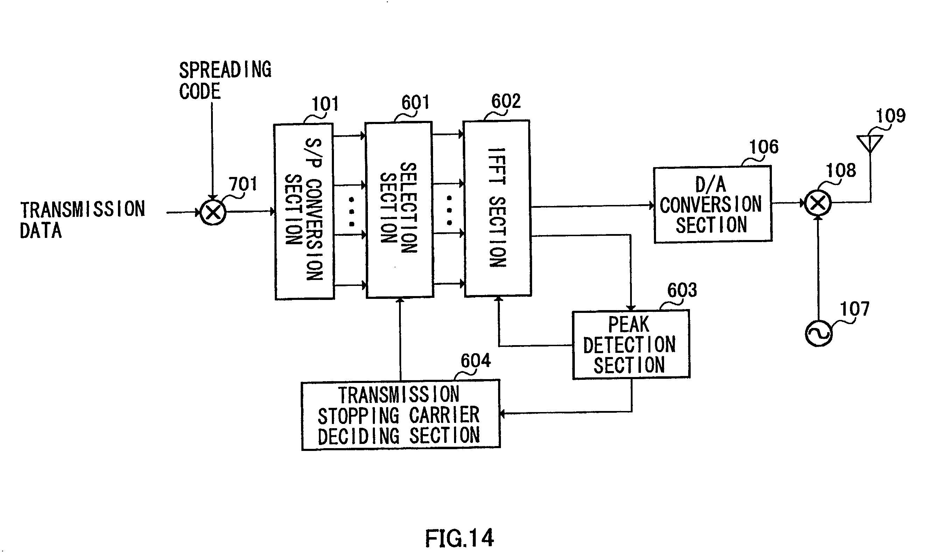

FIG.14 is a block diagram showing a configuration of a transmission apparatus equipped with a multi-carrier CDMA communication apparatus according to Embodiment 3 of the present invention;

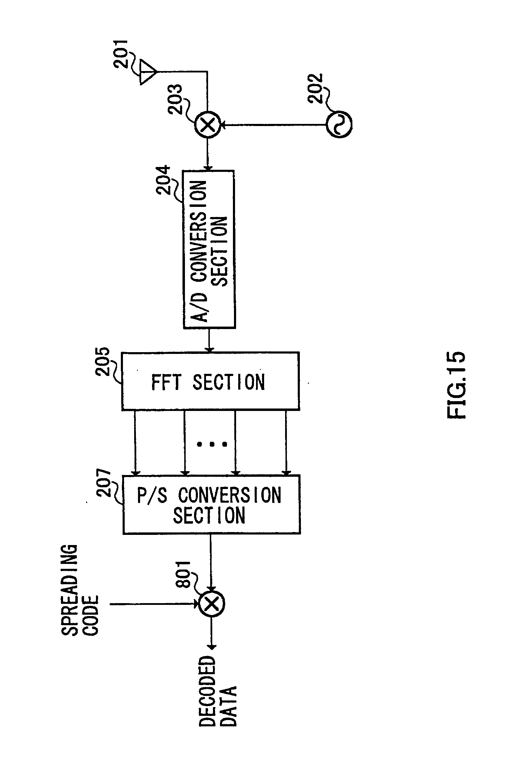

FIG.15 is a block diagram showing a configuration of a reception apparatus equipped with the multi-carrier CDMA communication apparatus according to Embodiment 3;

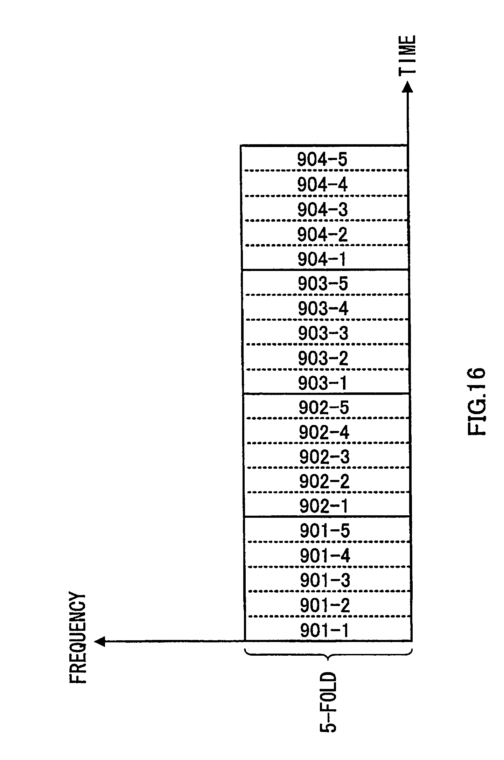

FIG.16 is a schematic view conceptually showing transmission data with a single sequence after spreading processing at the transmission apparatus equipped with the multi-carrier CDMA communication apparatus according to Embodiment 3;

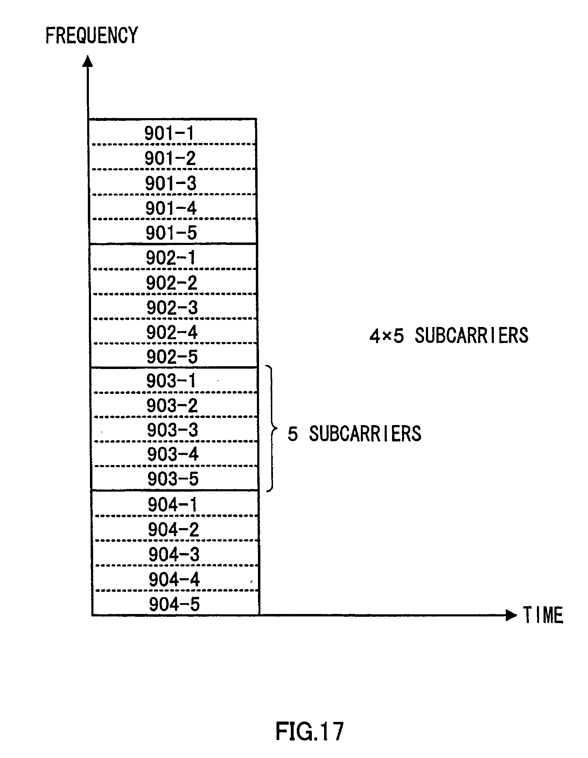

FIG.17 is a schematic view conceptually showing transmission data with a plurality of sequences at the transmission apparatus equipped with the multi-carrier CDMA communication apparatus according to Embodiment 3;

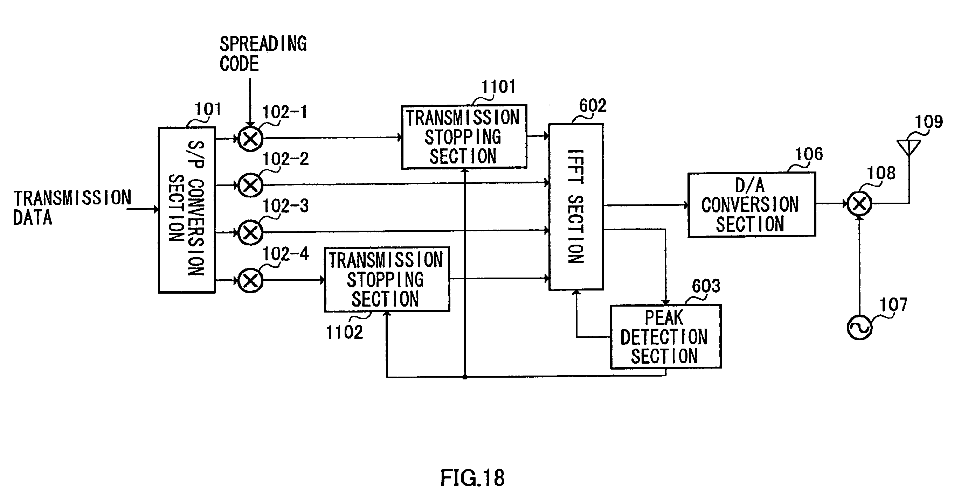

FIG.18 is a block diagram showing a configuration of a transmission apparatus equipped with a multi-carrier CDMA communication apparatus according to Embodiment 4 of the present invention;

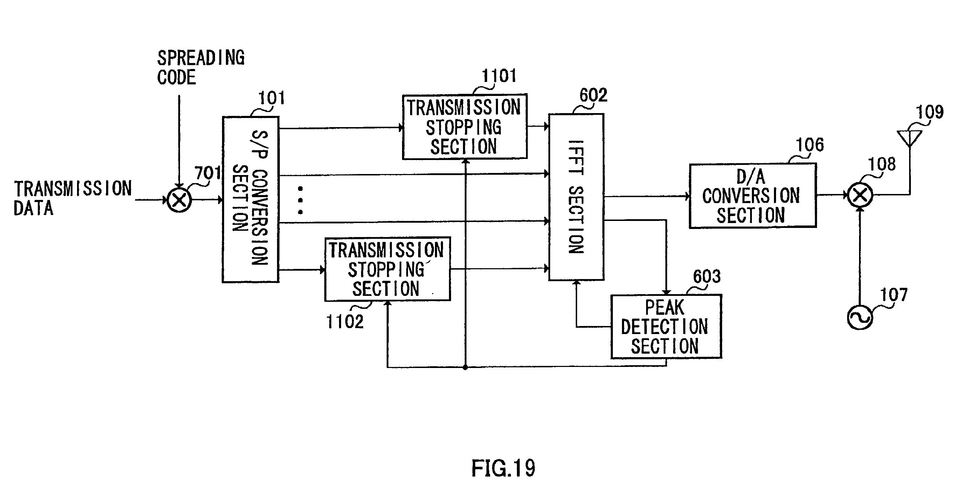

FIG.19 is a block diagram showing a configuration of a transmission apparatus equipped with a multi-carrier CDMA communication apparatus according to Embodiment 5 of the present invention;

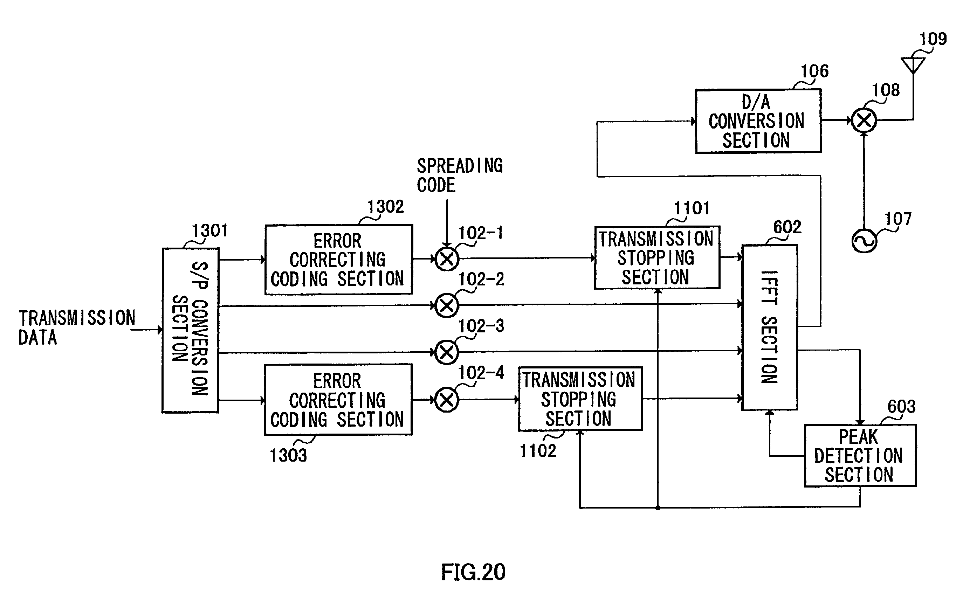

FIG.20 is a block diagram showing a configuration of a transmission apparatus equipped with a multi-carrier CDMA communication apparatus according to Embodiment 6 of the present invention;

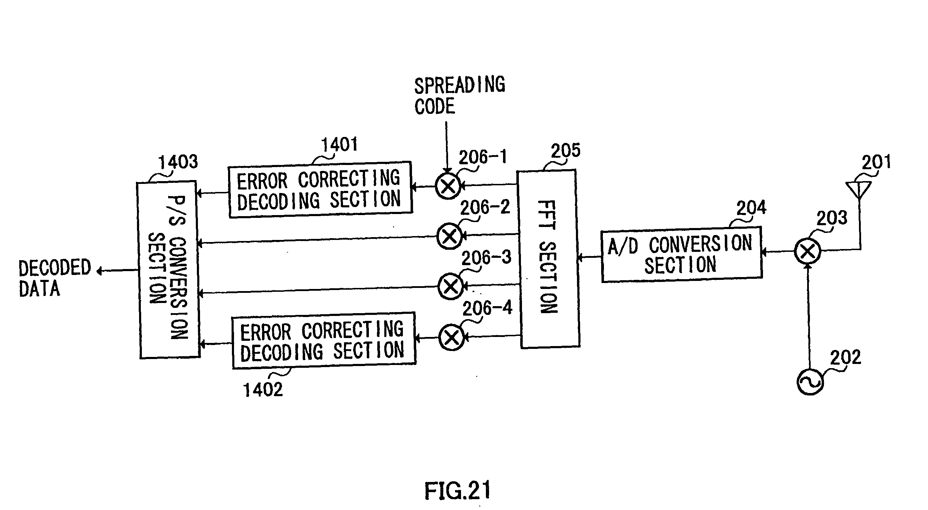

FIG.21 is a block diagram showing a configuration of a reception apparatus equipped with the multi-carrier CDMA communication apparatus according to Embodiment 6;

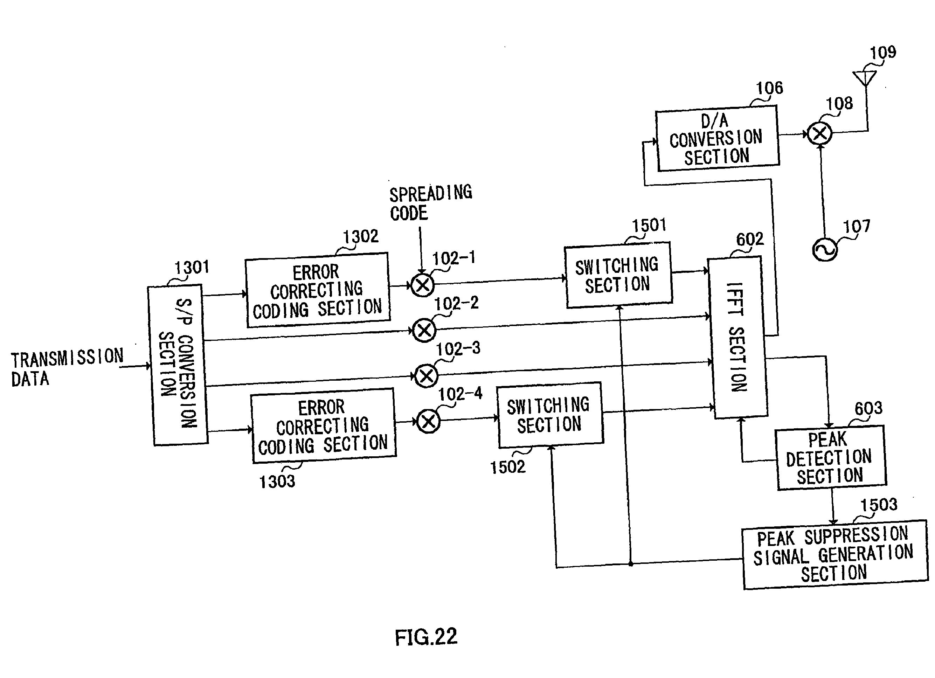

FIG.22 is a block diagram showing a configuration of a transmission apparatus equipped with a multi-carrier CDMA communication apparatus according to Embodiment 7 of the present invention; and

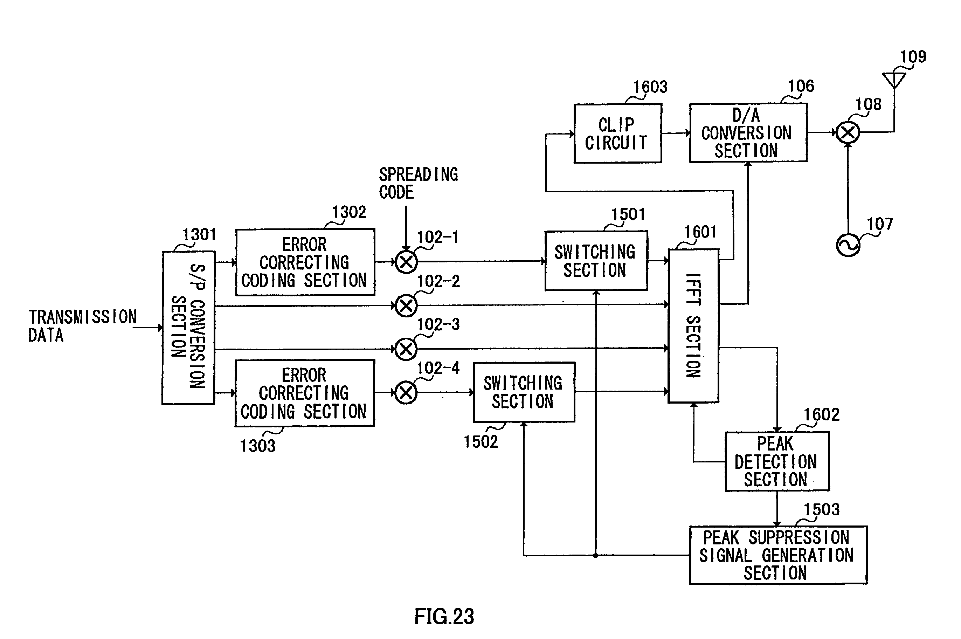

FIG.23 is a block diagram showing a configuration of a transmission apparatus equipped with a multi-carrier CDMA communication apparatus according to Embodiment 8 of the present invention.

### Best Mode for Carrying out the Invention

It is a main subject of the present invention to generate a multi-carrier signal by multiplexing information signals on all subcarriers, and, when peak power in excess of a threshold is generated in the multi-carrier signal generated, not sending this multi-carrier signal or multiplexing a signal to suppress peak power on at least one of all subcarriers and regenerating the multi-carrier signal when peak power exceeds the threshold.

With reference now to the attached drawings, embodiments of the present invention will be explained in detail below.

### (Embodiment 1)

This embodiment will describe a case that transmission of a multi-carrier signal whose peak power exceeds a threshold is stopped in an MC/DS-CDMA system. FIG.8 is a block diagram showing a configuration of a transmission apparatus equipped with a multi-carrier CDMA communication apparatus according to Embodiment 1 of the present invention.

In FIG.8, S/P conversion section 101 converts transmission data with a single sequence to transmission data with a plurality of sequences. Spreading section 102-1 to spreading section 102-4 carry out spreading processing on the transmission data from S/P conversion section 101. IFFT section 103 generates multi-carrier signals on a chip-by-chip basis by carrying out IFFT processing (frequency division multiplexing processing) using transmission data with a plurality of sequences after the spreading processing.

Peak detection section 104 detects on a chip-by-chip basis whether peak power in excess of a threshold is generated in the multi-carrier signal generated or not and sends the detection result to chip transmission stopping section 105. Chip transmission stopping section 105 controls the output of the multi-carrier signal generated to D/A conversion section 106 based on the detection result from peak detection section 104.

D/A conversion section 106 converts the multi-carrier signal from chip transmission stopping section 105 to an analog signal. Multiplication section 108 multiplies the multi-carrier signal converted to the analog signal by a local signal from oscillator 107 to carry out modulation processing on the multi-carrier signal, which has been converted to the analog signal. The multi-carrier signal subjected to the modulation processing is sent to a communication party via antenna 109.

FIG.9 is a block diagram showing a configuration of a reception apparatus equipped with the multi-carrier CDMA communication apparatus according to Embodiment 1 of the present invention. In FIG.9, the signal sent from the communication party is received by antenna 201. The above-described communication party is equipped with the transmission apparatus shown in FIG.8.

Multiplication section 203 generates a demodulated signal by multiplying the signal received from antenna 201 (received signal) by a local signal from oscillator 202. A/D conversion section 204 converts the demodulated signal generated to a digital signal.

FFT section 205 carries out Fast Fourier Transform (hereinafter referred to as "FFT") on the demodulated signal converted to the digital signal and extracts a signal transmitted by each subcarrier.

Despreading section 206-1 to despreading section 206-4 carry out despreading processing on the signals transmitted by the respective subcarriers. Parallel/serial (hereinafter referred to as "P/S") conversion section 207 converts the despread signals from despreading section 206-1 to despreading section 206-4 to decoded data with a single sequence.

Then, operations of the transmission apparatus and reception apparatus equipped with the multi-carrier CDMA communication apparatus according to this embodiment will be explained. 1st, an operation of the above-described transmission apparatus will be explained with reference to FIG.10 to FIG.12 in addition to FIG.8.

FIG.10 is a schematic view conceptually showing an example of transmission data to be input to the transmission apparatus equipped with the multi-carrier CDMA communication apparatus according to Embodiment 1 of the present invention. FIG.11 is a schematic view conceptually showing an example of transmission data with a plurality of sequences at the transmission apparatus equipped with the multi-carrier CDMA communication apparatus according to Embodiment 1 of the present invention. FIG.12 is a schematic view conceptually showing transmission data with a plurality of sequences after spreading processing at the transmission apparatus equipped with the multi-carrier CDMA communication apparatus according to Embodiment 1 of the present invention.

In FIG.8, transmission data with a single sequence (here, for example, transmission data corresponding to 4 symbols: see FIG.10) is converted to transmission data with a plurality of sequences by S/P conversion section 101. The number of sequences here corresponds to the total number of subcarriers (e.g., 4). For convenience of explanation, suppose the transmission data with a plurality of sequences shown in FIG.8 is transmission data with a 1st to 4th sequence from top to bottom. Here, transmission data with symbol 301 to symbol 304 becomes transmission data with the 1st to 4th sequence as shown in FIG.11.

The transmission data with the 1st to 4th sequence is subjected to spreading processing by spreading section 102-1 to spreading section 102-4 respectively. For ease of explanation, suppose each spreading section uses a spreading code with spreading factor 5 as an example. The transmission data with the 1st to 4th sequence through this spreading processing becomes chip-based signals with their frequency bands spread 5 times as shown in FIG.12. For example, the transmission data with the 1st sequence is subjected to spreading processing with its frequency band spread 5 times and becomes a chip-based signal having chip 501-1 to chip 501-5.

IFFT section 103 carries out IFFT processing (that is, frequency division multiplexing processing) using the transmission data (information signals) with the 1st to 4th sequence after the spreading processing. This frequency division multiplexing processing generates a multi-carrier signal with the transmission data with the 1st to 4th sequence after the spreading processing multiplexed on the 1st subcarrier to 4th subcarrier on a chip-by-chip basis. For example, at time T3, a multi-carrier signal is generated with chip 501-3 of transmission data with the 1st sequence, chip 502-3 of transmission data with the 2nd sequence, chip 503-3 of transmission data with the 3rd sequence and chip 504-3 of transmission data with the 4th sequence multiplexed on the 1st subcarrier to 4th subcarriers, respectively (see FIG.12). The chip-based multi-carrier signal generated is sent to peak detection section 104 and chip transmission stopping section 105.

Peak detection section 104 measures power of the multi-carrier signal from IFFT section 103 on a chip-by-chip basis and detects whether peak power exceeding a threshold has occurred in the multi-carrier signal on each chip or not. The detection result is sent to chip transmission stopping section 105.

Chip transmission stopping section 105 outputs the multi-carrier signal generated to D/A conversion section 106 based on the detection result from peak detection section 104 on a chip-by-chip basis. That is, a multi-carrier signal on a chip where no peak power exceeding a threshold is detected is sent to D/A conversion section 106 and on the contrary, a multi-carrier signal on a chip where peak power exceeding a threshold is detected is not sent to D/A conversion section 106 and discarded. As a result, instead of a multi-carrier signal on a chip where peak power exceeding a threshold is detected, a signal whose amplitude is quasi-zero is output to D/A conversion section 106.

For example, with reference to FIG.12, suppose attention is focused on the multi-carrier signal generated at time T3 (multi-carrier signal on the 3rd chip). The multi-carrier signal generated at time T3 is a signal generated with chip 501-3 of the transmission data with the 1st sequence, chip 502-3 of the transmission data with the 2nd sequence, chip 503-3 of the transmission data with the 3rd sequence and chip 504-3 of the transmission data with the 4th sequence multiplexed on the 1st to 4th subcarriers, respectively. In the case where peak detection section 104 detects that peak power exceeding a threshold has occurred in the multi-carrier signal on this 3rd chip, this multi-carrier signal is not output to D/A conversion section 106 but discarded by chip transmission stopping section 105.

In this case, symbol 301 to symbol 304 transmitted from the 1st subcarrier to 4th subcarrier respectively lack one chip (each representing information on chip 501-3 to chip 504-3).

The multi-carrier signal from chip transmission stopping section 105 is converted to an analog signal by D/A conversion section 106, then multiplied by a local signal from oscillator 107 by multiplication section 108 and subjected to modulation processing. The multi-carrier signal after modulation processing is sent to the communication party through antenna 109.

Then, an operation of the above-described reception apparatus will be explained with reference to FIG.9. In FIG.9, the signal sent from the above-described transmission apparatus is received by antenna 201. The signal received by antenna 201 (received signal) is multiplied by the local signal from oscillator 202 by multiplication section 203 to generate a demodulated signal. The demodulated signal generated is subjected to A/D conversion processing by A/D conversion section 204 into a digital signal.

The demodulated signal converted to a digital signal is subjected to FFT processing by FFT section 205 and the respective signals transmitted from the 1st to 4th subcarriers are then extracted. That is, FFT section 205 extracts the 1st to 4th demodulated signals.

The 1st to 4th demodulated signals extracted by FFT section 205 are subjected to despreading processing by despreading section 206-1 to despreading section 206-4 and then subjected to symbol decision. It goes without saying that the spreading code used for despreading section 206-1 to despreading section 206-4 is the same spreading code used for spreading section 102-1 to spreading section 102-4 shown in Fig 1.

Here, since the above-described transmission apparatus does not transmitted a multi-carrier signal on chips whose peak power exceeds a threshold, the 1st demodulated signal to 4th demodulated signal extracted from FFT section 205 may lack the relevant chips. For example, with reference to FIG.12, in the case where the transmission apparatus detects peak power exceeding a threshold in the multi-carrier signal generated at time T3, chips 501-3 to 504-3 are not sent, and therefore the 1st to 4th demodulated signals become signals lacking chips 501-3 to 504-3, respectively at the reception apparatus.

However, with reference to FIG.10 to FIG.12, each symbol is decomposed to a plurality of chips through spreading processing and sent. For example, symbol 301 is decomposed to 5 chips of chips 501-1 to 505-5 by spreading processing and sent.

Therefore, even if the 1st to 4th modulated signals are signals lacking some chips, despreading section 206-1 to despreading section 206-4 can perform appropriate symbol decision using the despread 1st to 4th demodulated signals. More specifically, with reference to FIG.10 to FIG.12, even if the multi-carrier signal generated at time T3 has not been sent, symbol 301, form example, is subjected to appropriate symbol decision based on signals obtained by despreading chips 501-1, 501-2, 501-4 and 501-5.

The signals subjected to symbol decision by despreading section 206-1 to despreading section 206-4 are converted to decoded data with a single sequence by P/S conversion section 207.

Thus, instead of providing subcarriers for transmitting only compensation signals for suppressing peak power in a fixed manner and subcarriers for transmitting only information signals, this embodiment provides all subcarriers as subcarriers for transmitting information signals and then multiplexes information signals subjected to spreading processing on these subcarriers to generate multi-carrier signals on a chip-by-chip basis. This suppresses reduction of the transmission efficiency.

Furthermore, while transmitting a multi-carrier signal whose peak power is not greater than a threshold as it is, this embodiment is not to send a multi-carrier signal whose peak power exceeds a threshold, and can thereby suppress influences of non-linear distortion of a power amplifier.

Furthermore, each symbol is decomposed to a plurality of chips through spreading processing and sent. Therefore, even if some chips included in each symbol are not sent (missing), each symbol is subjected to appropriate symbol decision through despreading processing and reproduced at the reception apparatus.

As shown above, according to this embodiment, it is possible to suppress peak power of a multi-carrier signal while suppressing reduction of the transmission efficiency.

### (Embodiment 2)

This embodiment will describe a case where transmission by at least one of all subcarriers is stopped for a multi-carrier signal whose peak power exceeds a threshold in Embodiment 1. FIG.13 is a block diagram showing a configuration of a transmission apparatus equipped with a multi-carrier CDMA communication apparatus according to Embodiment 2 of the present invention.

In FIG.13, under the control of transmission stopping carrier deciding section 604, which will be described later, selection section 601 outputs at least one of transmission data with the 1st to 4th sequence after spreading processing from spreading sections 102-1 to 102-4 to IFFT section 602.

IFFT section 602, under the control of peak detection section 603, which will be described later, carries out IFFT processing using transmission data after spreading processing and generates multi-carrier signals on a chip-by-chip basis. Furthermore, IFFT section 602, under the control of peak detection section 603, outputs only multi-carrier signals on chips where no peak power exceeding a threshold has occurred to D/A conversion section 106.

Peak detection section 603 detects whether peak power exceeding a threshold has occurred or not in the multi-carrier signals generated on a chip-by-chip basis and outputs the detection result to transmission stopping carrier deciding section 604. Furthermore, peak detection section 603 controls IFFT section 602 so that multi-carrier signals on chips where peak power exceeding a threshold has occurred are regenerated.

Of the transmission data with the 1st to 4th sequence, transmission stopping carrier deciding section 604 decides the transmission data to be output by selection section 601 to IFFT section 602 according to the detection result from peak detection section 603. Furthermore, transmission stopping carrier deciding section 604 controls selection section 601 so that the decided transmission data is output to IFFT section 602.

By the way, the configuration of the reception apparatus carrying out a radio communication with the transmission apparatus shown in FIG.13 is the same as that of the reception apparatus (FIG.9) in Embodiment 1, and therefore detailed explanations thereof are omitted.

Then, operations of the transmission apparatus and reception apparatus equipped with the multi-carrier CDMA communication apparatus according to this embodiment will be explained. Detailed explanations of the same operations in this embodiment as those in Embodiment 1 are omitted.

In FIG.13, the transmission data with the 1st to 4th sequence is subjected to spreading processing by spreading sections 102-1 to 102-4 and then output to selection section 601. Selection section 601 is normally controlled by transmission stopping carrier deciding section 604 so that the transmission data with the 1st to 4th sequence is output to IFFT section 602. Thus, the transmission data with the 1st to 4th sequence subjected to spreading processing is output from selection section 601 to IFFT section 602.

IFFT section 602 carries out IFFT processing using the transmission data with the 1st to 4th sequence after spreading processing. This IFFT processing generates a multi-carrier signal with the transmission data with the 1st to 4th sequence after spreading processing multiplexed on the 1st to 4th subcarriers, respectively. The chip-based multi-carrier signal generated is output to peak detection section 603.

Peak detection section 603 measures power of the multi-carrier signal from IFFT section 602 on a chip-by-chip basis and detects whether peak power exceeding a threshold has occurred or not in the multi-carrier signal on each chip.

Here, if peak power exceeding a threshold has not occurred in the multi-carrier signal on a certain chip, a control signal instructing that a multi-carrier signal on this chip should be output to D/A conversion section 106 is output from peak detection section 603 to IFFT section 602. As a result, a multi-carrier signal on a chip whose peak power is not greater than a threshold is output from IFFT section 602 to D/A conversion section 106.

On the other hand, in the case where peak power exceeding a threshold has occurred in a multi-carrier signal on a chip, a control signal instructing that a multi-carrier signal on this chip should be regenerated is output from peak detection section 603 to IFFT section 602 and the information that peak power exceeding a threshold has occurred in a multi-carrier signal on this chip is output from peak detection section 603 to transmission stopping carrier deciding section 604.

Of the transmission data with the 1st to 4th sequence, transmission stopping carrier deciding section 604 decides transmission data to be output to IFFT section 602. The transmission data to be output to IFFT section 602 may be selected randomly from the transmission data with the 1st to 4th sequence or preset transmission data may be selected from the transmission data with the 1st to 4th sequence.

To improve the characteristic of the received signal at the reception apparatus, this embodiment selects three pieces of transmission data (e.g., transmission data with the 1st to 3rd sequence) of the transmission data with the 1st to 4th sequence at the time of the 1st regeneration and selects three pieces of transmission data (e.g., transmission data with the 1st, 2nd and 4th sequence) at the time of the 2nd regeneration and their after, according to a combination different from that at the time of the 1st regeneration.

In the case where peak power in excess of a threshold is generated in the multi-carrier signal in all combinations, two out of four pieces of transmission data with the 1st to 4th sequence are selected. Thereafter, transmission data to be output to IFFT section 602 will be decided in the same way. As a result, when a multi-carrier signal is regenerated, of the transmission data with the 1st to 4th sequence, transmission data with at least one sequence is output from selection section 601 to IFFT section 602.

Hereafter, a control signal instructing that the transmission data with the decided sequence should be output to IFFT section 602 is output from transmission stopping carrier deciding section 604 to selection section 601. As a result, of the transmission data with the 1st to 4th sequence after spreading processing, the transmission data with at least one sequence decided by transmission stopping carrier deciding section 604 is output to IFFT section 602.

IFFT section 602 regenerates a multi-carrier signal on a chip where peak power exceeding a threshold has occurred. For example, with reference to FIG.12, when peak detection section 603 detects that peak power exceeding a threshold has occurred in a multi-carrier signal on a chip corresponding to time T3, IFFT section 602 regenerates a multi-carrier signal with chip 501-3 of transmission data with the 1st sequence, chip 502-3 of transmission data with the 2nd sequence and chip 503-3 of transmission data with the 3rd sequence multiplexed on the 1st subcarrier to 3rd subcarriers, respectively. At this time of regeneration, chip 504-3 in the transmission data with the 4th sequence is not multiplexed on the 4th subcarrier. In other words, a signal with an amplitude of quasi-zero is multiplexed on the 4th subcarrier.

Peak detection section 603 detects whether peak power exceeding a threshold has occurred or not in the multi-carrier signal regenerated by IFFT section 602 as described above. Peak detection section 603 carries out the above-described processing and in the case where no peak power exceeding a threshold has occurred in the multi-carrier signal on a regenerated chip, the multi-carrier signal on this regenerated chip is output from IFFT section 602 to D/A conversion section 106.

On the other hand, when peak power exceeding a threshold still occurs in the multi-carrier signal on a regenerated chip, transmission stopping carrier deciding section 604 changes the transmission data to be output to IFFT section 602 according to the above-described method and then IFFT section 602 regenerates a multi-carrier signal on this chip. The above-described operation is repeated hereafter until peak power exceeding a threshold no longer occurs in the multi-carrier signal on this chip.

The operation of the reception apparatus equipped with the multi-carrier CDMA communication apparatus according to this embodiment is the same as that of the reception apparatus equipped with the multi-carrier CDMA communication apparatus according to Embodiment 1, and therefore detailed explanations thereof except despreading sections 206-1 to 206-4 are omitted.

As explained in Embodiment 1, the 1st to 4th demodulated signals extracted by FFT section 205 are subjected to despreading processing by despreading sections 206-1 to 206-4 and then subjected to symbol decision.

When peak power in excess of a threshold is generated on a chip of the generated multi-carrier signal, of the transmission data with the 1st to 4th sequence, the above-described transmission apparatus does not transmit the above-described chip in transmission data with at least one sequence (here, suppose transmission data with the 4th sequence). Therefore, the 4th demodulated signal may lack the relevant chip. For example, with reference to FIG.12, when peak power exceeding a threshold is detected in a multi-carrier signal generated at time T3, chip 504-3 is not transmitted by the transmission apparatus, and therefore the 4th demodulated signal lacks chip 504-3 at the reception apparatus.

However, with reference to FIG.10 and FIG.12, symbol 304 is decomposed to a plurality of chips (that is, 5 chips of chips 504-1 to 504-5) through spreading processing and transmitted. Therefore, even if the 4th demodulated signal is a signal lacking some chips, despreading section 206-4 can perform appropriate symbol decision using the despread 4th demodulated signal. More specifically, even if chip 504-3 in a multi-carrier signal generated at time T3 has not been sent, symbol 304 is subjected to appropriate symbol decision based on a signal obtained by despreading chips 504-1, 504-2, 504-4 and 504-5.

Thus, instead of providing subcarriers for transmitting only a compensation signal to suppress peak power in a fixed manner and subcarriers for transmitting only information signals, this embodiment provides all subcarriers as subcarriers to transmit information signals, multiplexes the spread information signals on these subcarriers and thereby generates a chip-based multi-carrier signal. This suppresses reduction of the transmission efficiency.

Furthermore, when peak power exceeding a threshold does not occur in a multi-carrier signal on a chip, this embodiment is to send the multi-carrier signal on the chip itself and when peak power in excess of a threshold is generated in a multi-carrier signal on a chip, a multi-carrier signal on this chip is regenerated without multiplexing this chip in at least one piece of transmission data out of transmission data with a plurality of sequences on subcarrier. This makes it possible to reduce the number of information signals to be multiplexed on this chip and suppress peak power of the multi-carrier signal to be regenerated. Thus, it is possible to suppress influences of non-linear distortion in a power amplifier.

Furthermore, each symbol is decomposed to a plurality of chips through spreading processing and sent. Even if some chips included in each symbol have not been sent (missing), this allows the apparatus on the receiving side to apply appropriate symbol decision to each symbol through despreading processing and regenerate each symbol.

As shown above, this embodiment makes it possible to suppress peak power of a multi-carrier signal while suppressing reduction of the transmission efficiency.

### (Embodiment 3)

This embodiment will describe a case where Embodiment 2 is applied to an MC-CDMA system. FIG.14 is a block diagram showing a configuration of a transmission apparatus equipped with a multi-carrier CDMA communication apparatus according to Embodiment 3 of the present invention. In the transmission apparatus shown in FIG.14, the same components as those in Embodiment 2 (FIG.13) are assigned the same reference numerals and details explanations thereof are omitted. In FIG.14, spreading section 701 carries out spreading processing on transmission data with a single sequence and outputs the transmission data with a single sequence after the spreading processing to S/P conversion section 101.

FIG.15 is a block diagram showing a configuration of a reception apparatus equipped with the multi-carrier CDMA communication apparatus according to Embodiment 3 of the present invention. In the reception apparatus shown in FIG.15, the same components as those of the reception apparatus in Embodiment 2 (FIG.9) are assigned the same reference numerals and detailed explanations thereof are omitted. In FIG.15, despreading section 801 carries out despreading processing on the signal with a single sequence from P/S conversion section 207 and thereby outputs decoded data with a single sequence.

Then, operations of the transmission apparatus and reception apparatus equipped with the multi-carrier CDMA communication apparatus according to this embodiment will be explained. 1st, the operation of the above-described transmission apparatus will be explained with reference to FIG.16 and FIG.17 in addition to FIG.10 and FIG.14. Detailed explanations of the operation in this embodiment similar to that of Embodiment 2 are omitted.

FIG.16 is a schematic view conceptually showing transmission data with a single sequence after spreading processing at the transmission apparatus equipped with the multi-carrier CDMA communication apparatus according to Embodiment 3 of the present invention. FIG.17 is a schematic view conceptually showing transmission data with a plurality of sequences at the transmission apparatus equipped with the multi-carrier CDMA communication apparatus according to Embodiment 3 of the present invention.

In FIG.14, the transmission data with a single sequence (for example, transmission data corresponding to 4 symbols: see FIG.10) is subjected to spreading processing using a spreading code with spreading factor 5 by spreading section 701. In this way, the transmission data with a single sequence is converted to a chip-based signal (1st to fifth chips) with the frequency band spread 5 times as shown in FIG.16. For example, the frequency band of the transmission data of symbol 301 is spread 5 times and at the same time the signal is converted to a chip-based signal including chips 901-1 to 901-5.

The transmission data with a single sequence after the spreading processing is converted to transmission data with a plurality of sequences by S/P conversion section 101. The number of sequences here corresponds to the total number of subcarriers (4×5). For convenience of explanation, the transmission data with the plurality of sequence shown in FIG.14 is called "transmission data with the 1st sequence to 20th sequence" from top to bottom. With reference to FIG.17, chips 901-1 to 901-5 of symbol 301 become transmission data with the 1st to 5th sequence, chips 902-1 to 902-5 of symbol 302 become transmission data with the 6th to 10th sequence, chips 903-1 to 903-5 of symbol 303 become transmission data with the 11th to 15th sequence, and chips 904-1 to 904-5 of symbol 304 become transmission data with the 16th to 20th sequence. These transmission data with the 1st to 20th sequence are output to selection section 601.

Selection section 601,normally, is controlled by transmission stopping carrier deciding section 604 so as to output the transmission data with the 1st to 20th sequence to IFFT section 602. Thus, selection section 601 outputs the transmission data with the 1st to 20th sequence to IFFT section 602.

IFFT section 602 carries out IFFT processing using the transmission data with the 1st to 20th sequence after spreading processing. Through this IFFT processing, a multi-carrier signal with the transmission data with the 1st to 20th sequence multiplexed on the 1st to 20th subcarriers is generated symbol by symbol. The multi-carrier signal generated is output to peak detection section 603.

Peak detection section 603 measures power of the multi-carrier signal from the IFFT section 602 symbol by symbol and detects whether peak power exceeding a threshold has occurred or not in the multi-carrier signal of each symbol.

Here, in the case where no peak power exceeding a threshold has occurred in the multi-carrier signal of a symbol, a control signal instructing that the multi-carrier signal of this symbol should be output to D/A conversion section 106 is output from peak detection section 603 to IFFT section 602. As a result, a multi-carrier signal on a symbol whose peak power is not greater than a threshold is output from IFFT section 602 to D/A conversion section 106.

On the other hand, in the case where peak power exceeding a threshold has occurred in the multi-carrier signal of a symbol, a control signal instructing that a multi-carrier signal on this symbol should be regenerated is output from peak detection section 603 to IFFT section 602 and at the same time the information that peak power exceeding a threshold has occurred in the multi-carrier signal of this symbol is output from peak detection section 603 to transmission stopping carrier deciding section 604.

Of the transmission data with the 1st to 20th sequence, transmission stopping carrier deciding section 604 decides the transmission data to be output to IFFT section 602. The method of selecting transmission data to be output to IFFT section 602 is the same as that explained in Embodiment 2. In this embodiment, suppose the transmission data with the 1st to 19th sequence is decided as transmission data to be output to IFFT section 602.

After this, a control signal instructing that the transmission data with the decided sequence should be output to IFFT section 602 is output from transmission stopping carrier deciding section 604 to selection section 601. As a result, of the transmission data with the 1st to 20th sequence after spreading processing, transmission data with at least one sequence decided by transmission stopping carrier deciding section 604 (in this embodiment, the transmission data with the 1st to 19th sequence) are output to IFFT section 602.

IFFT section 602 regenerates a multi-carrier signal with the symbol in which peak power exceeding a threshold has occurred. For example, with reference to FIG. 17, when peak detection 603 detects that peak power exceeding a threshold has occurred in a multi-carrier signal on a symbol, IFFT section 602 regenerates a multi-carrier signal with the transmission data with the 1st (chip 901-1 of symbol 301) to 19th sequence (chip 904-4 of symbol 304) multiplexed on the 1st to 19th subcarriers. During this regeneration, the transmission data with the 20th sequence (chip 904-5 of symbol 304) is not multiplexed on the 20th subcarrier. In other words, a signal whose amplitude is quasi-zero is multiplexed on the 20th subcarrier.

About the multi-carrier signal regenerated by IFFT section 602, peak detection section 603 detects whether peak power exceeding a threshold has occurred or not as described above. In the case where peak detection section 603 detects that no peak power exceeding a threshold has occurred in the regenerated multi-carrier signal on a symbol after the above-described processing, IFFT section 602 outputs the regenerated multi-carrier signal on this symbol to D/A conversion section 106.

On the other hand, in the case where peak power exceeding a threshold still occurs in the regenerated multi-carrier signal on a symbol, transmission stopping carrier deciding section 604 changes the transmission data to be output to IFFT section 602 according to the above-described method, and then IFFT section 602 regenerates a multi-carrier signal on this symbol. Hereafter, the above-described operation is repeated until peak power exceeding a threshold no longer occurs in the multi-carrier signal on this symbol.

Then, an operation of the above-described reception apparatus will be explained with reference to FIG.15. Detailed explanations of the operation in FIG.15 similar to that of Embodiment 1 (FIG.9) are omitted.

In FIG.15, the demodulated signal converted to a digital signal is subjected to FFT processing by FFT section 205 and thereby each signal transmitted from the 1st to 20th subcarrier is extracted. That is, FFT section 205 extracts the 1st to 20th demodulated signals.

The 1st to 20th demodulated signals extracted by FFT section 205 are converted to a signal with a single sequence by P/S conversion section 207. This signal with a single sequence is subjected to despreading processing by despreading section 801 and then subjected to symbol decision. Decoded data with a single sequence is generated in this way.

Here, in the case where peak power exceeding a threshold has occurred in a symbol of the generated multi-carrier signal, transmission data with at least one sequence (here, suppose transmission data with the 20th sequence, that is, chip 904-5 of symbol 304) out of the transmission data with the 1st to 20th sequence is no longer sent by the previously mentioned transmitting apparatus. Thus, the 20th demodulated signal may become an erroneous signal. For example, with reference to FIG.17, in the case where the transmission apparatus detects peak power exceeding a threshold in the multi-carrier signal with the symbols shown in FIG.17, chip 904-5 of symbol 304 is not transmitted, and therefore the 20th demodulated signal becomes an erroneous signal at the reception apparatus.

However, with reference to FIG.10, FIG.16 and FIG.17, symbol 304 is decomposed to a plurality of subcarriers (that is, 16th subcarrier to 20th subcarrier) through spreading processing and transmitted. Therefore, even if the 20th demodulated signal is an erroneous signal, despreading section 801 can perform appropriate symbol decision using a despread signal. More specifically, symbol 304 is subjected to appropriate symbol decision based on the signal consisting of despread chip 904-1 to chip 904-4.

Thus, instead of providing subcarriers that only transmit a compensation signal for suppressing peak power in a fixed manner and subcarriers that only transmit information signals, this embodiment provides all subcarriers as subcarriers to transmit information signals, then to multiplexe spread information signals on these subcarriers and thereby generates a symbol-based multi-carrier signal. This suppresses reduction of the transmission efficiency.

Furthermore, in the case where no peak power exceeding a threshold has occurred in the multi-carrier signal on a symbol, the multi-carrier signal on this symbol is sent as is and in the case where peak power exceeding a threshold has occurred in the multi-carrier signal on a symbol, transmission data with at least one sequence out of transmission data with a plurality of sequences is not multiplexed on the subcarrier and the multi-carrier signal on this symbol is regenerated. The number of information signals to be multiplexed on this symbol is reduced in this way and it is thereby possible to suppress peak power of the multi-carrier signal to be regenerated. Thus, it is possible to suppress influences of non-linear distortion at the power amplifier.

Furthermore, each symbol is decomposed to a plurality of chips through spreading processing and each decomposed chip is multiplexed on the chip-specific subcarrier and transmitted. By doing so, even if some chips included in each symbol are not transmitted, each symbol is subjected to appropriate symbol decision through despreading processing and regenerated at the reception apparatus.

As shown above, this embodiment makes it possible to suppress peak power of a multi-carrier signal while suppressing reduction of the transmission efficiency.

### (Embodiment 4)

This embodiment will describe a case where for the multi-carrier signal whose peak power exceeds a threshold in Embodiment 2, transmission by predetermined subcarriers of all subcarriers is stopped. FIG.18 is a block diagram showing a configuration of a transmission apparatus equipped with a multi-carrier CDMA communication apparatus according to Embodiment 4 of the present invention. In the transmission apparatus shown in FIG.18, the components similar to those of the transmission apparatus in Embodiment 2 (FIG.13) are assigned the same reference numerals and detailed explanations thereof are omitted.

In FIG.18, transmission stopping section 1101 controls the output of the transmission data with the 1st sequence to IFFT section 602 according to the detection result from peak detection section 603. Transmission stopping section 1102 controls the output of the transmission data with the 4th sequence to IFFT section 602 according to the detection result from peak detection section 603.

The configuration of the reception apparatus equipped with the multi-carrier CDMA communication apparatus according to this embodiment is the same as that of Embodiment 1 (FIG.9) and detailed explanations thereof are omitted.

Then, an operation of the above-described transmission apparatus will be explained. Detailed explanations of operations in this embodiment similar to those in Embodiment 2 will be omitted. Peak detection section 603 measures power of a multi-carrier signal from IFFT section 602 on a chip-by-chip basis as in the case of Embodiment 2 and detects whether peak power exceeding a threshold has occurred or not in the multi-carrier signal on each chip.

In the case where peak power exceeding a threshold has occurred in the multi-carrier signal on a chip, a control signal instructing that the multi-carrier signal of this chip should be regenerated is output from peak detection section 603 to IFFT section 602 and the information that peak power exceeding a threshold has occurred in the multi-carrier signal on this chip is output from peak detection section 603 to transmission stopping section 1101 and transmission stopping section 1102.

As a result, the output of the transmission data with the 1st sequence to IFFT section 602 is stopped by transmission stopping section 1101 and the output of the transmission data with the 4th sequence to IFFT section 602 is stopped by transmission stopping section 1102. That is, of the transmission data with the 1st to 4th sequence after spreading processing, only the transmission with the 2nd sequence and the 3rd sequence are output to IFFT section 602.

IFFT section 602 regenerates a multi-carrier signal with the transmission data with the 2nd sequence and 3rd sequence subjected spreading processing multiplexed on the 2nd subcarrier and 3rd subcarrier, respectively. At the time of this regeneration, the transmission data with the 1st sequence and 4th sequence are not multiplexed on the 1st subcarrier and 4th subcarrier, respectively. In other words, a signal whose amplitude is quasi-zero is multiplexed on the 1st subcarrier or 4th subcarrier. Hereafter, the processing explained in Embodiment 2 will be performed.

This embodiment has described the case where two transmission stopping sections are provided to stop output of transmission data to IFFT section 602 when a multi-carrier signal is regenerated, but the number of these transmission stopping sections is not limited to a particular one.

Furthermore, this embodiment has described the case where all of a plurality of transmission stopping sections (that is, transmission stopping sections 1101 and 1102) stop output of transmission data to IFFT section 602 when a multi-carrier signal is regenerated for the first time, but it is also possible to increase the number of transmission stopping sections for stopping output of transmission data to IFFT section 602 according to the number of times multi-carrier signals are regenerated. This can improve the quality of a received signal at the reception apparatus.

Thus, this embodiment is to preset subcarriers whose transmission of transmission data is to be stopped during regeneration of a multi-carrier signal. Therefore, when the acceptable quality of-transmission data to be transmitted different between subcarriers, by stopping transmission of subcarrier with transmission data whose acceptable quality is low, it is possible to keep the quality of transmission data to be transmitted by other subcarriers at a satisfactory level. This makes it possible to transmit transmission data that satisfies the required quality while suppressing peak power of a multi-carrier signal.

### (Embodiment 5)

This embodiment will describe a case where Embodiment 3 is applied to an MC-CDMA system. FIG.19 is a block diagram showing a configuration of a transmission apparatus equipped with a multi-carrier CDMA communication apparatus according to Embodiment 5 of the present invention. In the transmission apparatus shown in FIG.19, the components similar to those of the transmission apparatus in Embodiment 4 (FIG.18) are assigned the same reference numerals and detailed explanations thereof are omitted.

As shown in FIG.19, the transmission apparatus equipped with the multi-carrier CDMA communication apparatus according to this embodiment has a configuration with spreading sections 102-1 to 102-4 removed from the transmission apparatus according to Embodiment 4 (FIG.18) and with spreading section 701 added to the transmission apparatus according to Embodiment 4. This spreading section 701 is similar to that of the transmission apparatus (FIG.14) according to Embodiment 3.

The configuration of the reception apparatus equipped with the multi-carrier CDMA communication apparatus according to this embodiment is similar to that of the reception apparatus according to Embodiment 3, and therefore detailed explanations thereof are omitted.

Thus, this embodiment is to preset subcarriers whose transmission of transmission data is to be stopped during regeneration of a multi-carrier signal. Therefore, when the acceptable quality of transmission data to be transmitted varies from one subcarrier to another, by stopping transmission of subcarrier with transmission data whose acceptable quality is low, it is possible to keep the quality of transmission data to be transmitted by other subcarriers at a satisfactory level. This makes it possible to transmit transmission data that satisfies the required quality while suppressing peak power of multi-carrier signals.

### (Embodiment 6)

This embodiment will describe a case where transmission data subjected to error correcting coding is multiplexed on the subcarriers whose transmission is stopped in Embodiment 4. FIG.20 is a block diagram showing a configuration of a transmission apparatus equipped with a multi-carrier CDMA communication apparatus according to Embodiment 6 of the present invention. In the transmission apparatus shown in FIG. 20, the components similar to those of the transmission apparatus in Embodiment 4 (FIG.18) are assigned the same reference numerals and detailed explanations thereof are omitted.

As shown in FIG.20, the transmission apparatus equipped with the multi-carrier CDMA communication apparatus according to this embodiment has a configuration with S/P conversion section 101 in the transmission apparatus (FIG.18) in Embodiment 4 replaced with S/P conversion section 1301, and error correcting coding sections 1302 and 1303 added.

S/P conversion section 1301 has a configuration similar to that of S/P conversion section 101 except the following point. That is, S/P conversion section 1301 outputs standard rate transmission data as the transmission data with the 2nd and 3rd sequences and outputs low rate transmission data as the transmission data with the 1st and 4th sequences to equalize the rates of transmission data input to spreading sections 102-1 to 102-4.

Error correcting coding sections 1302 and 1303 each perform predetermined error correcting coding processing on the transmission data with the 1st and 4th sequences and outputs the transmission data after error correcting coding processing to spreading sections 102-1 and 102-4, respectively.

FIG.21 is a block diagram showing a configuration of a reception apparatus equipped with the multi-carrier CDMA communication apparatus according to Embodiment 6 of the present invention. In the reception apparatus shown in FIG.21, the components similar to those of the reception apparatus in Embodiment 1 (FIG.9) are assigned the same reference numerals and detailed explanations thereof are omitted.

As shown in FIG.21, the reception apparatus equipped with the multi-carrier CDMA communication apparatus according to this embodiment has a configuration with P/S conversion section 207 of the reception apparatus (FIG.9) in Embodiment 1 replaced with P/S conversion section 1403 and error correcting decoding sections 1401 and 1402 added.

Error correcting decoding sections 1401 and 1402 perform error correcting decoding processing on the 1st and 4th demodulated signals subjected to symbol decision and output the demodulated signals after error correcting decoding to P/S conversion section 1403. P/S conversion section 1403 converts the demodulated signals with a plurality of sequences from error correcting decoding sections 1401 and 1402 and despreading sections 206-2 and 206-3 to decoded data with a single sequence.

Then, an operation of the above-described transmission apparatus will be explained. Detailed explanations of the operation in this embodiment similar to that of Embodiment 4 are omitted. In FIG.20, the transmission data with a single sequence is converted to standard rate transmission data with the 2nd and 3rd sequences and low rate transmission data with the 1st and 4th sequences by S/P conversion section 1301.

The standard rate transmission data with the 2nd and 3rd sequences are output to spreading sections 102-2 and 102-3, respectively. The low rate transmission data with the 1st and 4th sequences are subjected to predetermined error correcting coding processing by error correcting coding sections 1302 and 1303 and then output to spreading sections 102-1 and 102-4. All the transmission data input to spreading sections 102-1 to 102-4 have the same rate.

Here, for the above-described predetermined error correcting coding processing, it is also possible to use error correcting coding processing using block codes (Hamming code, BCH code, Reed-Solomon code and fire code, etc.) and it is also possible to use error correcting coding processing using convolutional codes (turbo code, self-orthogonal code, Hagelbarger code and Iwadare code, etc.).

Then, an operation of the above-described reception apparatus will be explained. Detailed explanations of the operation in this embodiment similar to that in Embodiment 1 are omitted. In FIG.21, the 2nd demodulated signal and 3rd demodulated signal subjected to symbol decision are output to P/S conversion section 1403. The 1st demodulated signal and 4th demodulated signal subjected to symbol decision are subjected to error correcting decoding processing corresponding to the error correcting coding processing used by the transmission apparatus by error correcting decoding sections 1401 and 1402, respectively and then output to P/S conversion section 1403.

The 2nd demodulated signal and 3rd demodulated signal subjected to symbol decision and the 1st demodulated signal and 4th demodulated signal subjected to error correcting decoding processing are converted to decoded data with a single sequence by P/S conversion section 1403.

Thus, in this embodiment, the transmission apparatus multiplexes transmission data subjected to error correcting coding processing on a subcarrier whose transmission is to be stopped and the reception apparatus carries out error correcting decoding processing on the signal transmitted by this subcarrier. Thus, even if it is not possible to decode the signal transmitted by this subcarrier correctly, the reception apparatus can reproduce transmission data correctly by carrying out error correcting decoding processing on this signal.

### (Embodiment 7)

This embodiment will describe a case where for a multi-carrier signal whose peak power exceeds a threshold in Embodiments 2 to 6, a signal for suppressing peak power is multiplexed on at least one of all subcarriers. Here, Embodiment 6 will be used as an example to explain this.

FIG.22 is a block diagram showing a configuration of a transmission apparatus equipped with a multi-carrier CDMA communication apparatus according to Embodiment 7 of the present invention. In the transmission apparatus shown in FIG.22, the components similar to those of the transmission apparatus in Embodiment 6 (FIG.20) are assigned the same reference numerals and detailed explanations thereof are omitted.

As shown in FIG.22, the transmission apparatus equipped with the multi-carrier CDMA communication apparatus according to this embodiment has a configuration with transmission stopping sections 1101 and 1102 in the transmission apparatus according to Embodiment 6 (FIG.20) replaced with switching sections 1501 and 1502 and peak suppression signal generation section 1503 added.

Peak suppression signal generation section 1503 outputs a peak suppression signal to switching sections 1501 and 1502 according to the detection result from peak detection section 603.

When a peak suppression signal is sent from peak suppression signal generation section 1503, switching sections 1501 and 1502 output this peak suppression signal instead of the transmission data with the 1st sequence and 4th sequence to IFFT section 602.

Since the configuration of the reception apparatus equipped with the multi-carrier CDMA communication apparatus according to this embodiment is similar to that of the reception apparatus according to Embodiment 6 (FIG.21) and therefore detailed explanations thereof are omitted.

Then, an operation of the above-described transmission apparatus will be explained. Detailed explanations of the operation in this embodiment similar to that of Embodiment 6 are omitted. In FIG.22, switching sections 1501 and 1502 normally output transmission data with the 1st sequence and 4th sequence to IFFT section 602, respectively. Thus, IFFT section 602 is fed the transmission data with the 1st sequence to 4th sequence subjected to spreading processing.

IFFT section 602 performs IFFT processing using the transmission data with the 1st sequence to 4th sequence after the spreading processing. In this way, a multi-carrier signal is generated with the transmission data with the 1st sequence to 4th sequence after the spreading processing multiplexed on the 1st subcarrier to the 4th subcarrier. The chip-based multi-carrier signal generated is output to peak detection section 603.

Peak detection section 603 measures power of the multi-carrier signal from IFFT section 602 on a chip-by-chip basis and detects whether peak power exceeding a threshold has occurred or not in the multi-carrier signal on each chip.

Here, in the case where no peak power exceeding a threshold has occurred in the multi-carrier signal on a chip, a control signal instructing that the multi-carrier signal on this chip should be output to D/A conversion section 106 is output from peak detection section 603 to IFFT section 602. As a result, a multi-carrier signal on a chip whose peak power is not greater than a threshold is output from IFFT section 602 to D/A conversion section 106.

On the other hand, in the case where peak power exceeding a threshold has occurred in the multi-carrier signal on a chip, a control signal instructing that the multi-carrier signal on this chip should be regenerated is output from peak detection section 603 to IFFT section 602 and at the same time the information that peak power exceeding a threshold has occurred in the multi-carrier signal on this chip is output from peak detection section 603 to peak suppression signal generation section 1503.

After this, a peak suppression signal is output from peak suppression signal generation section 1503 to switching sections 1501 and 1502. As the peak suppression signal, an appropriate (random) signal is used. As the peak suppression signal, a signal obtained through a calculation can also be used in addition to a random signal. Furthermore, it is also possible to store the signal obtained through a calculation in ROM, etc. beforehand and allow peak suppression signal generation section 1503 to generate a peak suppression signal using this ROM. By the way, the peak suppression signals output to switching sections 1501 and 1502 may be identical or different.

Switching sections 1501 and 1502 that have received the peak suppression signals output these peak suppression signals instead of the transmission data with the 1st sequence and 4th sequence to IFFT section 602.

IFFT section 602 regenerates a multi-carrier signal on the chip where peak power exceeding a threshold has occurred. For example, with reference to FIG.12, when peak detection section 603 detects that peak power exceeding a threshold has occurred in the multi-carrier signal on the chip corresponding to time T3, IFFT section 602 multiplexes a peak suppression signal instead of chip 501-3 in the transmission data with the 1st sequence on the 1st subcarrier, multiplexes a peak suppression signal instead of chip 504-3 in the transmission data with the 4th sequence on the 4th subcarrier, multiplexes chip 502-3 in the transmission data with the 2nd sequence and chip 503-3 in the transmission data with the 3rd sequence on the 2nd subcarrier and 3rd subcarrier, respectively to regenerate the multi-carrier signal.

Here, the peak suppression signal input to IFFT section 602 is an arbitrary (random) signal, and therefore this signal can be said to be a signal likely to suppress peak power of the multi-carrier signal regenerated by IFFT section 602. Therefore, the multi-carrier signal regenerated by IFFT section 602 is likely to be a signal with suppressed peak power.

As described above, peak detection section 603 detects whether peak power exceeding a threshold has occurred or not in the multi-carrier signal regenerated by IFFT section 602. Peak detection section 603 performs the above-described processing and when peak power exceeding a threshold has not occurred in the regenerated multi-carrier signal on a chip, IFFT section 602 outputs the regenerated multi-carrier signal on this chip to D/A conversion section 106.

On the other hand, when peak power exceeding a threshold still occurs in the regenerated multi-carrier signal on a chip, peak suppressing signal generation section 1503 outputs another arbitrary (random) signal as a peak suppression signal to switching sections 1501 and 1502 and then IFFT section 602 regenerates a multi-carrier signal on this chip using the changed peak suppression signal. Thereafter, the above-described operation is repeated until peak power exceeding a threshold no longer occurs in the multi-carrier signal on this chip.

This embodiment has described the case where the total number of subcarriers on which a peak suppression signal is multiplexed is 2, but no restriction is imposed on the total number of subcarriers on which a peak suppression signal is multiplexed.

In the case where a plurality of subcarriers on which a peak suppression signal is multiplexed is provided, it is also possible to increase the number of subcarriers on which a peak suppression signal is multiplexed when a multi-carrier signal is regenerated according to the number of times the multi-carrier signal is regenerated. This makes it possible to improve the characteristic of the received signal at the reception apparatus while reliably suppressing peak power of the multi-carrier signal.

Furthermore, this embodiment has described the case where a peak suppression signal is used in Embodiment 6 as an example, but it goes without saying that a peak suppression signal can also be used in any one of Embodiments 2 to 6.

Thus, instead of providing subcarriers for transmitting only a compensation signal to suppress peak power in a fixed manner and providing subcarriers for transmitting only transmission signals, this embodiment provides all subcarriers as subcarriers to transmit information signals, then multiplexes the information signals subjected to spreading processing on this subcarrier to generate a chip-based multi-carrier signal. This suppresses reduction of the transmission efficiency.

Furthermore, when peak power exceeding a threshold does not occur in a multi-carrier signal on a chip (a symbol in an MC-CDMA system), the multi-carrier signal on this chip (symbol) is sent as is, and when peak power in excess of a threshold is generated in a multi-carrier signal on a chip (a symbol), instead of this chip (symbol) in at least one piece of transmission data of transmission data with a plurality of sequences, a peak suppression signal is multiplexed on the subcarrier to regenerate a multi-carrier signal on this chip (symbol). This reduces the number of information signals to be multiplexed on this chip (symbol) and can thereby suppress peak power of the multi-carrier signal regenerated. This suppresses influences of non-linear distortion at a power amplifier.

Furthermore, each symbol is decomposed to a plurality of chips through spreading processing and sent (in the case of MC-CDMA, each symbol is decomposed to a plurality of chips through spreading processing and each decomposed chip is multiplexed on a chip-specific subcarrier and transmitted). Even if some chips included in each symbol are not transmitted (missing), this allows each symbol to be subjected to symbol decision appropriately through despreading processing and regenerated at the apparatus on the receiving side.

As shown above, this embodiment makes it possible to suppress peak power of a multi-carrier signal while suppressing reduction of the transmission efficiency.

### (Embodiment 8)

This embodiment will describe a case where clipping processing is applied to a multi-carrier signal generated or multi-carrier signal regenerated in Embodiments 1 to 7. Here, Embodiment 7 will be taken as an example to explain this.

FIG.23 is a block diagram showing a configuration of a transmission apparatus equipped with a multi-carrier CDMA communication apparatus according to Embodiment 8 of the present invention. In the transmission apparatus shown in FIG.23, the same components as those of the transmission apparatus in Embodiment 7 (FIG.22) are assigned the same reference numerals and details explanations thereof are omitted.

As shown in FIG.23, the transmission apparatus equipped with the multi-carrier CDMA communication apparatus according to this embodiment has a configuration with IFFT section 602 in the transmission apparatus according to Embodiment 7 (FIG.22) replaced by IFFT section 1601, peak detection section 603 replaced by peak detection section 1602, and clip circuit 1603 added.

Peak detection section 1602 has the same configuration as that of peak detection section 603 in Embodiment 7 except the following point. That is, when the number of times a multi-carrier signal of a same chip (symbol in the case of MC-CDMA) is regenerated reaches a predetermined number, peak detection section 1602 controls IFFT section 1601 so that regeneration of a multi-carrier signal for this chip (symbol) is stopped and that the first multi-carrier signal generated for this chip (symbol) is output to clip circuit 1603.

IFFT section 1601 has a configuration similar to that of IFFT section 602 according to Embodiment 7 except the following point. That is, IFFT section 1601 retains the first multi-carrier signal generated for a chip (symbol) , generates or regenerates a multi-carrier signal under the control by peak detection section 1602 and outputs the multi-carrier signal retained to clip circuit 1603.

Clip circuit 1603 carries out clipping processing on the multi-carrier signal from IFFT section 1601 and outputs the multi-carrier signal after the clipping processing to D/A conversion section 106.

Then, an operation of the above-described transmission apparatus will be explained. Detailed explanations of the operation in this embodiment similar to that of Embodiment 7 are omitted. When the first multi-carrier signal on a chip (symbol) is generated, IFFT section 1601 retains the generated multi-carrier signal. The multi-carrier signal for which no peak power exceeding a threshold has occurred is output to D/A conversion section 106 as explained in the embodiment above.

On the other hand, as described above, when peak detection section 1602 detects that peak power exceeding a threshold has occurred in the multi-carrier signal on a chip (symbol), IFFT section 1601 regenerates the multi-carrier signal on this chip (symbol) until peak power in the regenerated multi-carrier signal falls below the threshold.

At this time, when peak detection section 1602 detects that the number of times a multi-carrier signal for the same chip (symbol) is regenerated reaches a predetermined number, peak detection section 1602 outputs to IFFT section 1601 a control signal instructing that regeneration of a multi-carrier signal on this chip (symbol) should be stopped and that the retained multi-carrier signal should be output to clip circuit 1603.

As a result, IFFT section 1601 stops regeneration of the multi-carrier signal for a chip (symbol) and outputs the retained multi-carrier signal to clip circuit 1603.

Clip circuit 1603 carries out clipping processing on the multi-carrier signal from IFFT section 1601. Clipping processing includes a method of cutting power exceeding a threshold in the multi-carrier signal or a method of lowering the total level of the multi-carrier signal to reduce peak power of this multi-carrier signal to a threshold or below, etc.

This embodiment has described the case where when the number of times a multi-carrier signal on the same chip (symbol) is regenerated reaches a predetermined number, clipping processing is applied to the first multi-carrier signal generated, but it is also possible to apply clipping processing to a regenerated multi-carrier signal. This ensures suppression of peak power of the multi-carrier signal in the case where the peak power suppression effect is insufficient for the multi-carrier signal regenerated by stopping transmission by a predetermined subcarrier or even in the case where the peak power suppression effect is insufficient for the multi-carrier signal regenerated by multiplexing a peak suppression signal.

This embodiment has described the case where clipping processing is applied to a multi-carrier signal in Embodiment 7 as an example, but it goes without saying that clipping processing is applicable to any one of Embodiments 1 to 6. That is, when making a search for subcarriers whose transmission should be stopped or subcarriers on which a peak suppression signal should be multiplexed, if it is impossible to search for any subcarriers among predetermined number of subcarriers where peak power of a multi-carrier signal falls below a threshold, it is possible to apply clipping processing to the multi-carrier signal and thereby shorten the processing time and suppress peak power of the multi-carrier signal.

Thus, this embodiment applies clipping processing to a generated multi-carrier signal or a regenerated multi-carrier signal, and can thereby shorten the processing time and ensure suppression of peak power in the multi-carrier signal.

In Embodiment 1 to Embodiment 8 above, when the number of subcarriers is small, the number of patterns to be input to the IFFT section is limited. Therefore, it is possible to allow a lookup table (LUT) to store the IFFT calculation results obtained off line beforehand. Replacing the IFFT section with this LUT makes it possible to reduce the amount of calculation and processing time in the IFFT processing and suppress the scale of the apparatus as well.

Furthermore, Embodiment 1 to Embodiment 8 can be used combined with one another.

The multi-carrier CDMA communication apparatus in the present invention can be mounted on a communication terminal apparatus or a base station apparatus in a digital mobile unit communication system.

As described above, the present invention multiplexes information signals on all subcarriers to generate a multi-carrier signal, and when peak power in excess of a threshold is generated in the multi-carrier signal generated, the present invention stops transmitting this multi-carrier signal or multiplexes a signal for suppressing peak power on at least one of all subcarriers, regenerates a multi-carrier signal when peak power exceeds a threshold, and can thereby provide a multi-carrier CDMA communication apparatus capable of suppressing reduction of the transmission efficiency and suppressing peak power of the multi-carrier signal.

This application is based on the Japanese Patent Application No.2000-230471 filed on July 31, 2000, entire content of which is expressly incorporated by reference herein.

### Industrial Applicability

The present invention relates to a multi-carrier transmission system communication apparatus and is applicable to a multi-carrier CDMA communication apparatus combining a multi-carrier transmission system and CDMA transmission system in particular.

## Claims

1. A multi-carrier CDMA communication apparatus comprising:
converting means for converting an information signal with a single sequence to information signals with a plurality of sequences subjected to spreading processing;
generating means for generating a multi-carrier signal by multiplexing the respective information signals with said plurality of sequences subjected to spreading processing on sequence-specific carriers;
peak power detecting means for detecting peak power of said multi-carrier signal; and
transmitting means for transmitting only a multi-carrier signal whose peak power is not greater than a threshold.

2. A multi-carrier CDMA communication apparatus comprising:
converting means for converting an information signal with a single sequence to information signals with a plurality of sequences subjected to spreading processing;
generating means for generating a multi-carrier signal by multiplexing the respective information signals with said plurality of sequences subjected to spreading processing on sequence-specific carriers;
peak power detecting means for detecting peak power of said multi-carrier signal; and
regenerating means for regenerating amulti-carrier signal when said peak power exceeds a threshold by multiplexing a signal for suppressing peak power instead of an information signal on at least one specific carrier out of said carriers.

3. The multi-carrier CDMA communication apparatus according to claim 2, wherein said generating means multiplexes the information signal subjected to error correcting coding processing before spreading processing out of information signals with a plurality of sequences subjected to spreading processing on a specific carrier.

4. The multi-carrier CDMA communication apparatus according to claim 2, wherein said regenerating means uses a random signal as a signal for suppressing peak power.

5. The multi-carrier CDMA communication apparatus according to claim 2, wherein said regenerating means uses a signal whose amplitude is quasi-zero as the signal for suppressing peak power.

6. The multi-carrier CDMA communication apparatus according to claim 2, further comprising clipping means for carrying out clipping processing on a multi-carrier signal whose peak power exceeds a threshold out of the generated or regenerated multi-carrier signals.

7. The multi-carrier CDMA communication apparatus according to claim 2, wherein said converting means comprising:
sequence converting means for converting an information signal with a single sequence to information signals with a plurality of sequences; and
spreading means for carrying out spreading processing on said respective information signals with a plurality of sequences.

8. The multi-carrier CDMA communication apparatus according to claim 2, wherein said converting means comprising:
spreading means for carrying out spreading processing on the information signal with the single sequence; and
sequence converting means for converting an information signal with a single sequence subjected to spreading processing to information signals with a plurality of sequences.

9. A communication terminal apparatus equipped with a multi-carrier CDMA communication apparatus, said multi-carrier CDMA communication apparatus comprising:
converting means for converting an information signal with a single sequence to information signals with a plurality of sequences subjected to spreading processing;
generating means for generating a multi-carrier signal by multiplexing the respective information signals with said plurality of sequences subjected to spreading processing on sequence-specific carriers;
peak power detecting means for detecting peak power of said multi-carrier signal; and
transmitting means for transmitting only a multi-carrier signal whose peak power is not greater than a threshold.

10. A communication terminal apparatus equipped with a multi-carrier CDMA communication apparatus, said multi-carrier CDMA communication apparatus comprising:
converting means for converting an information signal with a single sequence to information signals with a plurality of sequences subjected to spreading processing;
generating means for generating a multi-carrier signal by multiplexing the respective information signals with said plurality of sequences subjected to spreading processing on sequence-specific carriers;
peak power detecting means for detecting peak power of said multi-carrier signal; and
regenerating means for regenerating a multi-carrier signal when said peak power exceeds a threshold by multiplexing a signal for suppressing peak power instead of an information signal on at least one specific carrier out of said carriers.

11. A base station apparatus equipped with a multi-carrier CDMA communication apparatus, said multi-carrier CDMA communication apparatus comprising:
converting means for converting an information signal with a single sequence to information signals with a plurality of sequences subjected to spreading processing;
generating means for generating a multi-carrier signal by multiplexing the respective information signals with said plurality of sequences subjected to spreading processing on sequence-specific carriers;
peak power detecting means for detecting peak power of said multi-carrier signal; and
transmitting means for transmitting only a multi-carrier signal whose peak power is not greater than a threshold.

12. A base station apparatus equipped with a multi-carrier CDMA communication apparatus, said multi-carrier CDMA communication apparatus comprising:
converting means for converting an information signal with a single sequence to information signals with a plurality of sequences subjected to spreading processing;
generating means for generating a multi-carrier signal by multiplexing the respective information signals with said plurality of sequences subjected to spreading processing on sequence-specific carriers;
peak power detecting means for detecting peak power of said multi-carrier signal; and
regenerating means for regenerating a multi-carrier signal when said peak power exceeds a threshold by multiplexing a signal for suppressing peak power instead of an information signal on at least one specific carrier of said carriers.

13. A multi-carrier CDMA communication method comprising:
a converting step of converting an information signal with a single sequence to information signals with a plurality of sequences subjected to spreading processing;
a generating step of generating a multi-carrier signal by multiplexing the respective information signals with said plurality of sequences subjected to spreading processing on sequence-specific carriers;
a peak power detecting step of detecting peak power of said multi-carrier signal; and
a transmitting step of transmitting only a multi-carrier signal whose peak power is not greater than a threshold.

14. A multi-carrier CDMA communication method comprising:
a converting step of converting an information signal with a single sequence to information signals with a plurality of sequences subjected to spreading processing;
a generating step of generating a multi-carrier signal by multiplexing the respective information signals with said plurality of sequences subjected to spreading processing on sequence-specific carriers; a peak power detecting step of detecting peak power of said multi-carrier signal; and
a regenerating step of regenerating a multi-carrier signal when said peak power exceeds a threshold by multiplexing a signal for suppressing peak power instead of an information signal on at least one specific carrier of said carriers.
